# EUROPEAN PATENT SPECIFICATION

(11) **EP 3 184 717 B1**
(45) Date of publication and mention of the grant of the patent: **31.10.2018**
(21) Application number: 16206818.3
(22) Date of filing: 23.12.2016
(51) Int. Cl.: E05B 81/56, B60R 16/03, H03K 17/22, E05B 83/16

(54) **CONTROL CIRCUIT FOR A LOCK OF A VEHICLE**
STEUERSCHALTUNG FÜR EIN SCHLOSS EINES FAHRZEUGS
CIRCUIT DE COMMANDE DE VERROU DE VÉHICULE

(30) Priority: 23.12.2015 IT UB20159430
(43) Date of publication of application: 28.06.2017
(73) Proprietor: Iveco S.p.A., 10156 Torino (IT)
(72) Inventor: CONSIGLIO, Salvatore, 10149 TORINO (IT); GAGLIARDI, Michele, 10036 SETTIMO TORINESE (IT)
(74) Representative: Franzolin, Luigi

(56) References cited:
- DE-A1- 3 929 987
- DE-B3-102006 046 032
- FR-A1- 2 785 010
- US-A- 4 860 002

## Description

The invention relates to a control circuit for a lock of a vehicle, in particular a tailgate lock of a vehicle.

Some vehicles, for example minivans, are provided with a tailgate, which - in turn - is equipped with an electro-lock, which can be operated by a control circuit, which can be activated by means of a control button located on the tailgate and enabled through a remote control.

According to a known solution, the electro-lock is controlled by means of a relay circuit comprising a plurality of relays, which are supplied with power in a continuous manner. The continuous power supply of the relays causes, though, high current consumptions, for example in the range of 100 mA, and, as a consequence, the battery of the vehicle has a tendency to run down in case of prolonged parking times.

As a possible solution to this problem, a timer relay
can be used, which is capable of allowing the activation of the relay circuit for a predetermined amount of time.

However, the timer relay adds itself to the plurality of relays already present in the circuit, thus increasing dimensions and costs.

Furthermore, the timer relay allows the circuit to be active for a limited time interval; consequently, once said time interval has elapsed, you can no longer open the tailgate without reactivating the relay circuit.

Examples of known electro-lock of tailgate of a vehicle are disclosed in DE3929987 A1, DE102006046032 B3 or US4860002 A.

Therefore, there is a strong need to have a control circuit for the electro-lock of the tailgate of a vehicle, which enables the activation thereof in a continuous manner, does not involve high current consumptions and, at the same time, leads to small dimensions and reduced costs.

The object of the invention is to solve the technical problem described above.

In order to do so, the invention provides a circuit according to claim 1.

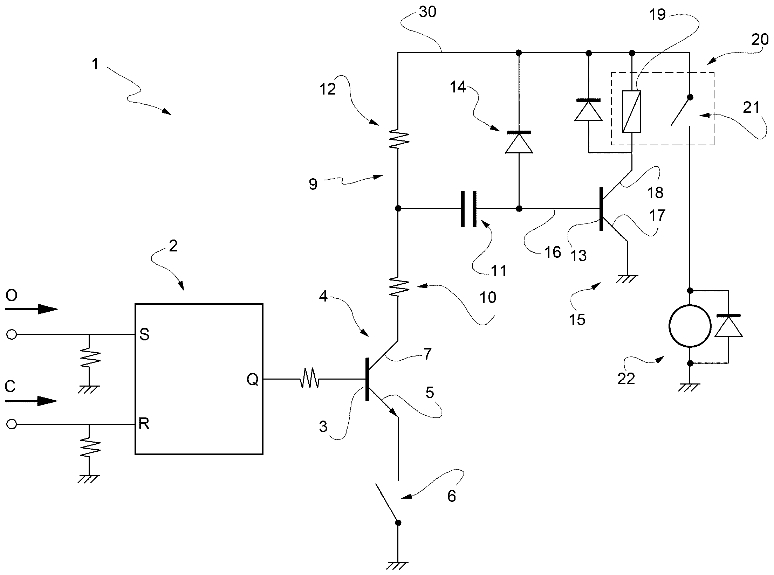

The invention will be best understood upon perusal of the following detailed description of a preferred embodiment, which is provided by way of non-limiting example, with reference to the accompanying drawing, whose single figure shows an electric diagram of a circuit according to the invention.

The figure shows the electric diagram of a control circuit 1 of a tailgate lock of a minivan (not shown).

The circuit 1 comprises, at the input, a flip-flop 2, namely an SR flip-flop, having a set input S adapted to receive an impulse opening signal 0 and a reset input R adapted to receive an impulse closing signal C and an output Q. The signals 0 and C are conveniently generated by a receiver of a remote control (not shown) in response to the operation of the buttons, the opening and closing button respectively, on the remote control.

The output Q is connected to a base 3 of a first transistor 4, namely an NPN transistor, having an emitter 5 that can be connected to the ground by means of a circuit breaker 6. The circuit breaker 6 is conveniently operated by a button on the tailgate (not shown) or by another manual operating member associated with a handle of the tailgate.

Finally, the first transistor 4 has a collector 7, which is connected, by means of a resistor 10, to a capacitor 11 connected to a base 13 of a second transistor 15 by means of a branch 16 and to a resistor 12 connected to a power supply branch 30 operating at a power supply voltage Vcc.

The capacitor 11 and the resistor 12 define an RC circuit 9, which is sized so as to obtain a pre-set time constant τ.

The circuit 1 further comprises a diode 14 having an anode connected to the branch 16 and a cathode connected to the power supply branch 30.

The second transistor 15 conveniently is a PNP transistor. The second transistor 15 comprises a collector 17 connected to the ground and an emitter 18 connected to a coil 19 of a relay 20 connected, in turn, to the power supply branch 30. The relay 19 further comprises a circuit breaker 21, which is operated by the coil 18 and selectively connects an actuator 22 of the tailgate lock, for example an electric motor, to the power supply branch 30.

The circuit 1 works as follows.

The user, by pressing the opening button of the remote control, sends a signal 0 to the set input S of the flip-flop 5; the output Q thereof switches from the logic status 0 to the logic status 1, thus causing the saturation of the NPN transistor 4.

The logic status Q=1 lasts until the closing button on the remote control is pressed, thus generating a closing signal C at the input R of the flip-flop 2.

When the user presses the button of the tailgate, the circuit breaker 6 closes and causes the saturation of the PNP transistor 15; at the same time, the capacitor 11 charges up. The duration of said charge depends on the time constant τ of the RC circuit 9. Preferably, the RC circuit 9 is sized so as to obtain the charge of the capacitor 11 in an amount of time smaller than 5 s, more preferably equal to approximately 2 s.

When the PNP transistor 15 is saturated, the coil 19 of the relay 20 is excited and, by closing the circuit breaker 21, operates the actuator 22 of the electro-lock 22.

Once the charge of the capacitor 11 has run down, the PNP transistor 15 shifts to an interdiction condition; as a consequence, the coil 19 of the relay 20 is unexcited, the circuit breaker 21 opens and the supply of power to the actuator 22 is interrupted.

Even if the user were to keep pressing the button of the tailgate for an amount of time longer than the aforesaid charge time, the PNP transistor 15 would remain in the interdiction status, thus preserving the actuator 22.

When the closing button of the remote control is pressed, an impulse signal C is sent to the input R of the flip-flop 2, thus causing the output Q to reach the logic value 0.

Therefore, the transistor 4 is in an interdiction status and trying to operate the button of the tailgate has no effect.

The features of the control circuit of a vehicle lock according to the invention reveal evident advantages that can be obtained using it.

The circuit 1 allows you to open the tailgate without time limits, after after having been enabled by the remote control, though with a reduced current consumption, as, compared to the prior art, one single relay is used for a limited amount of time. The consumption values that can be obtained by the circuit 1 are in the range of 1 mA or less.

Moreover, the circuit 1 is compact and economic.

The interruption of the supply of power to the actuator 22 after a pre-set amount of time further allows you to increase the useful life thereof.

Finally, the circuit described above can be subjected to changes and variants, which do not go beyond the scope of protection set forth in the appended claims.

In particular, the functions of the circuit 1 could be obtained with a microprocessor circuit.

## Claims

1. A Control circuit (1) for controlling an actuator (22) of a vehicle tailgate lock, comprising:
- memory means (2) for memorizing an enable status (Q) in response to a lock opening enable signal (0);
- control means (6) for controlling opening of the manual operation lock; and
- operating means (15, 20) for operating the actuator (22) in response to said control means (6) and in the presence of said enable status (Q).

2. A circuit according to claim 1, **characterised in that** it comprises inhibition means (9, 15) for inhibiting said operating means (20) after a pre-set time starting from the manual operation of said control means (6).

3. A circuit according to claim 1 or 2, **characterised in that** said control means comprise a manually operated circuit breaker (6).

4. A circuit according to any one of the preceding claims, **characterised in that** said memory means comprise a flip-flop (2) having a set input (S) adapted to receive an opening signal (0) and a reset input (R) adapted to receive a closing signal (C), the flip-flop comprising an output representing said status (Q).

5. A circuit according to any one of the claims from 1 to 4, **characterised in that** said inhibition means comprise an RC circuit (9) and circuit breaker means (15) interposed between said RC circuit (9) and said operating means (20), said circuit breaker means (15) being configured to switch in response to an output of said RC circuit (9).

6. A circuit according to claim 5, **characterised in that** it comprises an NPN transistor (4) having a base (3) connected to the output of said flip-flop (2), an emitter (5) connected to said control means (6) and a collector (7) connected to said RC circuit (9).

7. A circuit according to claim 5 or 6, **characterised in that** said circuit breaker means comprise a PNP transistor (15) having a base (13) connected to said RC circuit (9), a collector (17) connected to ground and an emitter (18) connected to said operating means (20).

8. A circuit according to any one of the preceding claims, **characterised in that** said operating means comprise a relay (20) .

## Patentansprüche

1. Steuerschaltung (1) zur Steuerung eines Aktors (22) eines Fahrzeugheckteilschlosses, umfassend:
- Speichermittel (2) zur Speicherung eines Freigabestatus (Q) als Reaktion auf ein Schlossöffnungsfreigabesignal (O);
- Steuermittel (6) zur Steuerung der Öffnung der manuellen Betätigungssperre; und
- Betätigungsmittel (15, 20) zur Betätigung des Aktors (22) als Reaktion auf die Steuermittel (6) und bei Vorhandensein des Freigabestatus.

2. Steuerschaltung gemäß Anspruch 1, **dadurch gekennzeichnet, dass** sie Sperrmittel (9, 15) umfasst zur Sperrung der Betätigungsmittel (20) nach einer vorgegebenen Zeit beginnend mit der manuellen Betätigung der Steuermittel (6).

3. Steuerschaltung gemäß Anspruch 1 oder 2, **dadurch gekennzeichnet, dass** die Steuermittel eine manuell betätigte Schaltungsunterbrechung (6) umfassen.

4. Steuerschaltung gemäß einem der vorhergehenden Ansprüche, **dadurch gekennzeichnet, dass** die Speichermittel eine Kippschaltung (2) umfassen mit einer setzenden Eingabe (S), die geeignet ist ein Öffnungssignal (O) zu empfangen und einer zurücksetzenden Eingabe (R), die geeignet ist ein Schließsignal (C) zu empfangen, wobei die Kippschaltung eine Ausgabe umfasst, die den Status (Q) darstellt.

5. Steuerschaltung gemäß einem der Ansprüche 1 bis 4, **dadurch gekennzeichnet, dass** die Sperrmittel eine RC-Schaltung (9) und Schaltungsunterbrechungsmittel (15) umfassen, wobei letztere zwischen der RC-Schaltung (9) und den Betätigungsmitteln (20) zwischengeschaltet sind, welche Schaltungsunterbrechungsmittel (15) konfiguriert sind, in Reaktion auf eine Ausgabe der RC-Schaltung (9) zu schalten.

6. Steuerschaltung gemäß Anspruch 5, **dadurch gekennzeichnet, dass** sie einen NPN-Transistor (4) umfasst, der eine Basis (3), die mit der Ausgabe der Kippschaltung verbunden ist, einen Emitter (5), der mit den Steuermitteln (6) verbunden ist und einen Kollektor (7) besitzt, der mit der RC-Schaltung (9) verbunden ist.

7. Steuerschaltung gemäß Anspruch 5 oder 6, **dadurch gekennzeichnet, dass** die Schaltungsunterbrechungsmittel einen PNP-Transistor (15) umfassen, der eine Basis (13), die mit der RC-Schaltung (9) verbunden ist, einen Kollektor (17), der mit der Masse verbunden ist, und einen Emitter (18) besitzt, der mit den Betätigungsmitteln (20) verbunden ist.

8. Steuerschaltung gemäß einem der vorhergehenden Ansprüche, **dadurch gekennzeichnet, dass** die Betätigungsmittel ein Relais (20) umfassen.

## Revendications

1. Circuit de commande (1) destiné à commander un actionneur (22) de verrou de hayon de véhicule, comprenant :
- un moyen formant mémoire (2) destiné à mémoriser un état d'activation (Q) en réponse à un signal d'activation d'ouverture de verrou (0) ;
- un moyen de commande (6) destiné à commander l'ouverture du verrou à actionnement manuel ; et
- des moyens d'actionnement (15, 20) destinés à actionner l'actionneur (22) en réponse audit moyen de commande (6) et en présence dudit état d'activation (Q) .

2. Circuit selon la revendication 1, **caractérisé en ce qu'**il comprend des moyens d'inhibition (9, 15) destinés à inhiber ledit moyen d'actionnement (20) après un temps prédéfini à compter de l'actionnement manuel dudit moyen de commande (6).

3. Circuit selon la revendication 1 ou 2, **caractérisé en ce que** ledit moyen de commande comprend un disjoncteur à actionnement manuel (6).

4. Circuit selon l'une quelconque des revendications précédentes, **caractérisé en ce que** ledit moyen formant mémoire comprend une bascule bistable (2) comportant une entrée de mise à un (S) destinée à recevoir un signal d'ouverture (0) et une entrée de mise à zéro (R) destinée à recevoir un signal de fermeture (C), la bascule bistable comprenant une sortie représentant ledit état (Q).

5. Circuit selon l'une quelconque des revendications 1 à 4, **caractérisé en ce que** lesdits moyens d'inhibition comprennent un circuit RC (9) et un moyen formant disjoncteur (15) intercalé entre ledit circuit RC (9) et ledit moyen d'actionnement (20), ledit moyen formant disjoncteur (15) étant conçu pour commuter en réponse à une sortie dudit circuit RC (9).

6. Circuit selon la revendication 5, **caractérisé en ce qu'**il comprend un transistor NPN (4) comportant une base (3) connectée à la sortie de ladite bascule bistable (2), un émetteur (5) connecté audit moyen de commande (6) et un collecteur (7) connecté audit circuit RC (9).

7. Circuit selon la revendication 5 ou 6, **caractérisé en ce que** ledit moyen formant disjoncteur comprend un transistor PNP (15) comportant une base (13) connectée audit circuit RC (9), un collecteur (17) connecté à la terre et un émetteur (18) connecté audit moyen d'actionnement (20).

8. Circuit selon l'une quelconque des revendications précédentes, **caractérisé en ce que** ledit dispositif d'actionnement comprend un relais (20).
